# EUROPÄISCHE PATENTSCHRIFT

(11) **EP 1 859 493 B1**
(45) Veröffentlichungstag und Bekanntmachung des Hinweises auf die Patenterteilung: **17.03.2010**
(21) Anmeldenummer: 06723467.4
(22) Anmeldetag: 16.03.2006
(51) Int. Cl.: H01L 51/00

(54) **PRÄGEVERFAHREN ZUR HERSTELLUNG VON ELEKTRONISCHEN EINHEITEN AUSGEHEND VON EINER MEHRLAGIGEN AUSGANGSSTRUKTUR**
STAMPING METHOD FOR PRODUCING ELECTRONIC UNITS FORM A MULTI-LAYERED STARTING STRUCTURE
PROCEDE D'ESTAMPAGE DESTINE A LA FABRICATION D'UNITES ELECTRONIQUES A PARTIR D'UNE STRUCTURE DE DEPART MULTICOUCHE

(30) Priorität: 18.03.2005 DE 102005013125
(43) Veröffentlichungstag der Anmeldung: 28.11.2007
(73) Patentinhaber: O-Flexx Technologies GmbH, 47228 Duisburg (DE)
(72) Erfinder: BISGES, Michael, 40885 Ratingen (DE)
(74) Vertreter: Kohlmann, Kai
(86) Internationale Anmeldenummer: PCT/EP2006/002418
(87) Internationale Veröffentlichungsnummer: WO 2006/097304

(56) Entgegenhaltungen:
- WO-A-02/29912
- WO-A-2004/055920
- WO-A-2005/004194

## Beschreibung

Die Erfindung betrifft ein Verfahren zur Herstellung von elektronischen Einheiten in einer mehrlagigen ebenen Ausgangsstruktur. Elektronische Einheiten sind insbesondere Halbleiterbauelemente, wie beispielsweise TFT-Transistoren, sowie Halbleiterbauelemente umfassende Schaltungen.

Im Rahmen der Polymerelektronik gibt es Ansätze zur Herstellung preiswerter Halbleiter aus Kunststoff. Das in der Elektronikindustrie in erster Linie als Halbleitermaterial zum Einsatz gelangende Silizium ist bei einfachen elektronischen Anwendungen vielfach nicht erforderlich. Um die Kosten elektronischer Schaltungen auf der Basis der Polymerelektronik zu reduzieren, wird unter anderem an der technischen Universität Chemnitz seit längerem das Drucken von Polymerschaltungen untersucht. Dort gelang es, Kunststoff-Transistoren in einem Massendruckverfahren herzustellen. Bei dem Druckverfahren werden Kunststoffmoleküle, die entweder leitend, halbleitend oder isolierend sind, in feinen Schichten übereinander gedruckt. Von der Konsistenz her sind die Kunststoffe wie Tinte zu verwenden. Hieraus resultiert allerdings das Problem, dass selbst bei technisch höchstmöglicher Auflösung die gedruckten Polymer-Transistoren bei weitem nicht an die Leistung von Silizium-Transistoren heranreichen.

Der Druck eines Halbleiters gestaltet sich im Einzelnen beispielsweise wie folgt:
- Zunächst wird die Basiselektrode auf ein isolierendes Substratmaterial aus Kunststoff aufgedruckt.
- Anschließend wird eine Isolationsschicht oberhalb der Basiselektrode aufgebracht, die beispielsweise aus einem organischen Dielektrikum besteht.
- Auf die Isolationsschicht werden die Kollektor- und Emitterelektrode aufgedruckt,
- gefolgt von dem Aufbringen des Halbleitermaterials. Ein typisches Halbleitermaterial für das Drucken von TFT-Transistoren ist beispielsweise P3HT (Poly 3-Hexalthiophene).

Der wesentliche Vorteil der gedruckten Polymerelektronik besteht darin, dass sich diese in sehr hoher Auflage preiswert drucken lässt und sich daher für kurzlebige Elektronik-Bauteile, wie beispielsweise Gepäckanhänger oder Verpackungsetiketten eignet.

Als Hauptnachteile der gedruckten Polymerelektronik sind die erreichbare Strukturgröße, die mangelnde Homogenität des Drucks sowie die teilweise nicht ausreichende Langzeitstabilität der gedruckten Halbleiter zu nennen.

Geringere Strukturgrößen von deutlich unterhalb 5 µm sind jedoch erforderlich, um ausreichende Schaltgeschwindigkeiten der Halbleiterbauelemente zu erzielen, insbesondere bei der Verwendung von organischen Materialien die ohnehin eine geringere Schaltgeschwindigkeit als anorganische, herkömmliche Materialien nach sich ziehen. Die mangelhafte Gleichförmigkeit der im Druckverfahren aufgetragenen Beschichtungen ändern die Verhaltensweise des Halbleiterbauelementes. Dies ist insbesondere dann nicht tolerabel, wenn die gedruckten Halbleiterbauelemente zur Steuerung von Displays verwendet werden.

Neben den reinen Druckverfahren zur Herstellung insbesondere von TFT-Transistoren ist aus der WO 02/29912 A1 ein Verfahren zur Herstellung organischer Halbleiter bekannt geworden, bei dem in eine mehrlagige ebene Ausgangsstruktur mit einer leitenden, halbleitenden und isolierenden Schicht mittels eines Prägewerkzeugs Kerben in die mehrlagige Ausgangsstruktur eingebracht werden. Bei dem Prägeschritt wird die erste Lage der mehrlagigen Ausgangsstruktur abgeschert. Die durch das Prägen gebildeten streifenförmigen, parallel zueinander angeordneten Elektroden für die Emitter- bzw. Kollektorelektroden des Halbleiters werden elektrisch durch die Kerben getrennt, wobei der minimale Abstand zwischen zwei benachbarten streifenförmigen Elektroden 0,6 µm beträgt. Anschließend wird auf die Struktur eine halbleitende Polymerschicht und die Isolationsschicht für die Basis aufgebracht. Schließlich wird in einem letzten Schritt im Wege eines Druckverfahrens die Basiselektrode aus einem leitenden Polymer in die Kerbe eingebracht. Sowohl die halbleitende Schicht als auch die Isolationsschicht folgen dabei dem Verlauf der durch das Prägewerkzeug hergestellten Kerbe, so dass die leitende Polymerbasiselektrode ausschließlich mit der Oberfläche der Isolationsschicht in der Rille in Kontakt kommt.

Die WO 2004 /055920 A2 offenbart ein Verfahren zur Herstellung einer elektronischen Einheit, insbesondere eines FET-Transistors aus einer mehrlagigen Ausgangstruktur. Es wird ein topographisches Profil in einem Substrat aus elektrisch isolierendem Material mittels eines Prägestempels erzeugt, insbesondere eine Vertiefung. Auf der ebenen Oberfläche des Substrats befindet sich eine leitende Schicht. Nach dem Prägeschritt wird eine Lage aus halbleitendem Material und eine Lage Dielektrikum abgeschieden. Schließlich wird in die eingeprägte Vertiefung die Gate-Elektrode eingebracht.

Ausgehend von diesem Stand der Technik liegt der Erfindung die Aufgabe zugrunde, ein effizienteres Verfahren zur Herstellung von elektronischen Einheiten, insbesondere Halbleiterbauelementen vorzuschlagen, das die massenhafte preiswerte Herstellung von Halbleiterbauelementen bei kleineren Strukturen unabhängig von dem verwendeten Material für die elektrisch leitenden und halbleitenden Schichten ermöglicht und das eine höhere Gleichmäßigkeit der hergestellten Halbleiter gewährleistet. Insbesondere soll das Verfahren auch eine massenhafte und kostengünstige Herstellung von leistungsfähigen Halbleitern, insbesondere TFT-Transistoren sowie daraus hergestellten Schaltungen unter Verwendung herkömmlicher Halbleitermaterialien, wie insbesondere Silizium erlauben.

Die Lösung dieser Aufgabe beruht auf dem Gedanken, senkrecht zu der Oberfläche einer mehrlagigen Ausgangsstruktur liegende Schnittflächen, die in einem Prägeschritt erzeugt werden, als Funktionsflächen für den Aufbau eines Halbleiterbauelementes, insbesondere TFT-Transistors, zu nutzen. Die mehrlagige ebene Ausgangsstruktur weist eine auf einem Substrat angeordnete, plastisch verformbare Prägeschicht auf sowie eine erste und zweite Schicht oberhalb der Prägeschicht. Die erste und zweite Schicht weisen eine unterschiedliche elektrische Leitfähigkeit auf und zwischen der ersten und zweiten Schicht ist eine elektrisch isolierende Schicht angeordnet. Oberhalb besagt in diesem Zusammenhang lediglich, dass sich die erste und zweite Schicht über der Prägeschicht befinden, jedoch nichts über die Orientierung der Ausgangstruktur im Raum.

Im einzelnen wird die Aufgabe durch ein Verfahren zur Herstellung von elektronischen Einheiten in der mehrlagigen Ausgangsstruktur gelöst, bei dem in einem Prägeschritt mittels eines Prägewerkzeugs die oberhalb der Prägeschicht angeordneten Schichten abschnittsweise an senkrecht zu der Oberfläche der Ausgangstruktur liegenden Schnittflächen abgeschert und so weit in die Prägeschicht gedrückt werden, dass die senkrechten Schnittflächen unterschiedlicher Schichten in Kontakt kommen.

Aufgrund des erfindungsgemäßen Prägeverfahrens entfällt die Notwenigkeit eines Druckvorgang, der zum einen die Gleichförmigkeit der hergestellten Strukturen sowie deren maximale Auflösung negativ beeinträchtigt.

Nach dem erfindungsgemäßen Verfahren spielt es keine entscheidende Rolle, ob die erste Schicht aus elektrisch leitendem oder elektrisch halbleitendem Material besteht, sofern gewährleistet ist, dass die zweite Schicht eine unterschiedliche elektrische Leitfähigkeit aufweist.

Um bei der Herstellung von TFT-Transistoren eine elektrische Trennung der aus der elektrisch leitenden Schicht durch den Prägeschritt hergestellten Basis -,Emitter - und Kollektorelektrode sicherzustellen, müssen die von dem Prägewerkzeug abgescherten Schichten so weit in die Prägeschicht gedrückt werden, dass die senkrechten Schnittflächen zwischen den abgescherten Abschnitten der elektrisch leitenden Schicht sich nicht berühren. Die Prägetiefe wird vorzugsweise so bemessen, dass eine möglichst große Kontaktfläche zwischen der elektrisch leitenden und der halbleitenden Schicht an den senkrechten Schnittflächen erzeugt wird.

Weist die Ausgangsstruktur lediglich eine Schicht aus elektrisch halbleitendem Material auf und besteht die erste Schicht aus elektrisch leitendem Material, genügt es, wenn ein zwischen zwei nicht eingeprägten Abschnitten liegender Abschnitt in die Prägeschicht gedrückt wird.

Ist die zweite Schicht die elektrisch leitende Schicht, befindet sich der nicht eingeprägte Abschnitt zwischen den beiden eingeprägten Abschnitten.

Um TFT-Transistoren mit unterschiedlichem Schaltverhalten herzustellen, ist es in einer Ausgestaltung der Erfindung vorgesehen, dass mindestens eine oberhalb oder unterhalb der ersten und zweiten Schicht aufgebrachte weitere Schicht aus elektrisch halbleitendem Material mittels des Prägewerkzeugs abschnittsweise an senkrecht zu der Oberfläche der Ausgangsstruktur liegenden Schnittflächen abgeschert und zusammen mit den übrigen Schichten in die Prägeschicht gedrückt wird. Die weiteren Schichten bestehen aus dotiertem halbleitendem Material, insbesondere aus N+ bzw. N- dotiertem Silizium. Jede weitere Schicht kann durch Ausdampfen von Silizium und anschließende Dotierung mit einer Ionenquelle hergestellt werden.

Ist die weitere Schicht aus elektrisch halbleitendem Material oberhalb der ersten und zweiten Schicht aufgebracht ist es erforderlich, dass vier Abschnitte an senkrecht zu der Oberfläche der Ausgangsstruktur liegenden Schnittflächen abgeschert und in die Prägeschicht gedrückt werden. Dabei wird ein mittlerer, die Basiselektrode als elektrisch leitende Schicht enthaltender Abschnitt nicht eingeprägt, der zwischen jeweils zwei weiteren Abschnitten an zwei gegenüberliegenden Seiten liegt, die unterschiedlich tief in die Prägeschicht gedrückt werden.

Ist die weitere Schicht aus elektrisch halbleitendem Material unterhalb der ersten und zweiten Schicht unmittelbar auf der Prägeschicht aufgebracht, genügt es indes, wenn drei Abschnitte an senkrecht zu der Oberfläche der Ausgangsstruktur liegenden Schnittflächen abgeschert und in die Prägeschicht gedrückt werden. In diesem Fall wird der mittlere, die Basiselektrode umfassende Abschnitt in die Prägeschicht gedrückt, während die zwei unmittelbar angrenzenden Abschnitte auf dem Niveau der Ausgangsstruktur verbleiben. Der die Basiselektrode enthaltende mittlere Abschnitt wird dabei so weit in die Prägeschicht gedrückt, dass die senkrechten Schnittflächen der Halbleiterschicht mit den senkrechten Schnittflächen der Schichten aus dotiertem. Halbleitermaterial der angrenzenden Abschnitte in Kontakt kommen. Die beiden äußeren Abschnitte der Ausgangsstruktur werden so weit in die Prägeschicht gedrückt, dass die senkrechten Schnittflächen der elektrisch leitenden Schicht mit den senkrechten Schnittflächen der Schicht aus dotierten Halbleitermaterial in Kontakt kommen.

Der Prägevorgang wird unabhängig von der Anzahl der eingeprägten Abschnitte der Ausgangsstruktur stets so durchgeführt, dass die die Emitter- bzw. Kollektorelektrode bildenden abgescherten Abschnitte an ihren Schnittflächen nicht mit demjenigen Abschnitt in Kontakt kommen, der die Basiselektrode bildet. Des Weiteren müssen die Kollektor- bzw. Emitterelektrode bildenden Abschnitte mit ihren Schnittflächen jeweils mit den Schnittflächen einer elektrisch halbleitenden Schicht eines angrenzenden Abschnitts in Kontakt kommen.

Zur Erhöhung des Ausstoßes des erfindungsgemäßen Verfahrens wird der Prägeschritt vorzugsweise an einer bewegten Ausgangsstruktur, insbesondere an einer von Rolle zu Rolle geführten Folienbahn oder an einer Ausgangsstruktur im Bogenformat durchgeführt. Die Folie bildet dabei das Substrat, auf dem die plastisch verformbare Prägeschicht sowie sämtliche anderen Schichten angeordnet sind. Der Prägeschritt wird an der bewegten Ausgangsstruktur vorzugsweise fortlaufend mittels eines auf der Ausgangsstruktur abrollenden Prägezylinders durchgeführt.

Selbstverständlich lässt sich das Verfahren jedoch auch an einer ruhenden Ausgangsstruktur durchführen. Der Prägeschritt wird dann beispielsweise mit einem flächigen Prägewerkzeug mit quaderförmigen Prägeformen durchgeführt, wobei das Prägewerkzeug mit einem Prägeschritt eine Vielzahl von elektronischen Einheiten, insbesondere TFT-Transistoren oder andere Halbleiter erzeugt.

Um die elektronischen Einheiten nach dem Prägeschritt vor mechanischen, chemischen und elektrischen Einflüssen zu schützen und zu fixieren, wird in einer Ausgestaltung der Erfindung nach dem Prägeschritt eine Beschichtung auf der geprägten Struktur aufgebracht. Als Coating kommen insbesondere Schutzlacke in Betracht, die mittels elektromagnetischer Strahlung, insbesondere UV-Strahlung gehärtet werden.

Eine UV-Bestrahlung während des Prägeschritts dient der Aushärtung der geprägten Struktur sowie einer Verbesserung der Kontaktierung an den Schnittflächen unterschiedlicher Abschnitte.

Eine weitere Möglichkeit zur Verbesserung der Kontaktierung an den Schnittflächen besteht darin, dass zumindest für die erste und zweite Schicht ein Material mit unterschiedlichem Ausdehnungsverhalten verwendet wird. Indem der Struktur während und/oder nach dem Prägeschritt gezielt Wärme zu- bzw. von ihr abgeführt wird, lässt sich die Verbindung an den Schnittflächen aufgrund des unterschiedlichen Ausdehnungsverhaltens gezielt beeinflussen.

Noch eine weitere Möglichkeit zur Verbesserung der Kontaktierung besteht darin, dass die Struktur während und/oder nach dem Prägeschritt mit Schallschwingungen, insbesondere Ultraschallschwingungen beaufschlagt wird. Der durch die Schallschwingungen hervorgerufene Verdichtungseffekt in der Schnittfläche ruft eine physikalische und/oder chemische Bindung zwischen den unterschiedlichen Schichten an der Schnittfläche hervor.

Schließlich kann die Kontaktierung an den Schnittstellen dadurch verbessert werden, dass zumindest eine der Schichten aus einem Material mit fotochemisch aktivierbaren Substanzen (Fotoinitiatoren) besteht, die durch elektromagnetische Bestrahlung aktiviert werden und eine Vernetzungsreaktion an der Schnittstelle auslösen. Der Einsatz von Fotoinitiatoren kommt insbesondere dann in Betracht, wenn die halbleitenden und leitenden Schichten aus organischem Material bestehen.

Zusammenfassend lassen sich folgende Vorteile des erfindungsgemäßen Verfahrens nennen:
- Durch den erfindungsgemäßen Prägeschritt lassen sich wesentlich höhere Auflösungen bei der Herstellung von elektronischen Einheiten, insbesondere Halbleiterbauelementen erzielen. Die erreichbaren Strukturgrößen sind kleiner 100 nm, während nach dem Stand der Technik lediglich Strukturgrößen von minimal 50.000 nm realisierbar sind.
- Aufgrund des erfindungsgemäßen Verfahrens kann die Schicht aus elektrisch leitendem Material beispielsweise aufgesputtert werden und aus Reinstmetall bestehen. Dies ermöglicht geringe elektrische Widerstände und extrem dünne Schichten. Das Aufdrucken sogenannter Metal-Flakes für die Elektroden der Halbleiterbauelemente, wie nach dem Stand der Technik erforderlich, entfällt.
- Der Prägeschritt erlaubt die Ausbildung von scharfen Kanten und Ecken in der Struktur.
- Das erfindungsgemäße Verfahren lässt die Verarbeitung von anorganischen und organischen Leitern und Halbleitern zu, was bei den Druckverfahren bisher nicht möglich war.
- Schließlich wird durch das erfindungsgemäße Verfahren die Möglichkeit eröffnet, die Ausgangsstruktur als Halbzeug vorzubereiten, insbesondere in Form einer mit allen erforderlichen Schichten versehenen Folie, die anschließend geprägt wird.

Auf einem Substrat ist zunächst eine plastisch verformbare Prägeschicht aufgebracht. Die Dicke der Prägeschicht beträgt zwischen 100 - 10.000 nm, unabhängig davon ob die leitende Schicht aus organischem oder anorganischem Material besteht. Wird die leitende Schicht aus anorganischem Material aufgesputtert ist bereits eine Schichtdicke von 100 nm ausreichend.

Eine gute Wärmeabfuhr aus den nach dem erfindungsgemäßen Verfahren hergestellten elektronischen Einheiten und damit ein Schutz gegen Zerstörung lässt sich dadurch erzielen, dass das Substrat und/oder die Prägeschicht aus wärmeleitendem Material bestehen.

Die thermoplastische Prägeschicht kann insbesondere aus Polymeren bestehen. Wenn die Prägeschicht darüber hinaus Fotoinitiatoren aufweist, ist eine Lichthärtung des thermoplastischen Materials nach der Prägung möglich, um die Formstabilität zu erreichen.

Die oberhalb der Prägeschicht angeordnete erste und zweite Schicht weisen eine unterschiedliche elektrische Leitfähigkeit auf. Eine der beiden Schichten ist elektrisch leitend, während die andere Schicht elektrisch halbleitend ist. Die elektrisch leitende Schicht ist insbesondere eine Metallschicht, die beispielsweise aus Gold, Silber, Aluminium oder Kupfer besteht. In Betracht kommen jedoch auch organische Leiter. Die Metallschicht kann aufgesputtert oder als Lösung von Metallpartikeln aufgebracht werden.

Die elektrisch halbleitenden Schichten können aus sämtlichen üblichen Halbleitermaterialien, insbesondere Silizium oder Germanium, jedoch auch aus organisch halbleitendem Material, insbesondere Polymeren bestehen. Auch die halbleitenden Schichten können aufgesputtert werden.

Die zwischen der ersten und zweiten Schicht aus leitendem bzw. halbleitendem Material angeordnete elektrisch isolierende Schicht besteht vorzugsweise aus einem organischen oder anorganischen Dielektrikum.

Das sämtliche Schichten tragende Substrat ist insbesondere eine PET-Folie. Alternativ kommen Substrate aus Polypropylen oder orientiertem Polypropylen in Betracht. Denkbar ist es jedoch auch, als Substrat eine Metallfolie zu verwenden, um eine optimale Wärmeableitung zu ermöglichen.

Um in einem Prägeschritt mehrere Halbleiterstrukturen gleichzeitig herzustellen, ist es in einer Ausgestaltung der erfindungsgemäßen Struktur vorgesehen, dass sämtliche oberhalb der Prägeschicht angeordneten Schichten der Ausgangsstruktur Unterbrechungen aufweisen. Die Unterbrechungen sind auf der Ausgangsstruktur vorzugsweise in regelmäßigen Abständen und gleicher Orientierung angeordnet. Handelt es sich bei der Ausgangsstruktur um eine Folienbahn, sind die Unterbrechungen insbesondere in Längsrichtung auf der Folienbahn in gleichmäßigen Abständen angeordnet.

Nachfolgend wird das erfindungsgemäße Verfahren anhand der Figuren näher erläutert. Es zeigen
- **Figur 1**: eine schematische Darstellung des erfindungsgemäßen Verfahrens mit Hilfe eines rotierenden Prägezylinders,
- **Figur 2**: eine Darstellung einer mehrlagigen ebenen Ausgangsstruktur zur Verwendung in dem erfindungsgemäßen Verfahren,
- **Figur 3**: eine Darstellung zur Veranschaulichung der Herstellung eines TFT-Transistors mit dem erfindungsgemäßen Verfahren sowie
- **Figur 4**: eine Darstellung zur Veranschaulichung der Herstellung eines dotierten Halbleiterbauelementes mit dem erfindungsgemäßen Verfahren

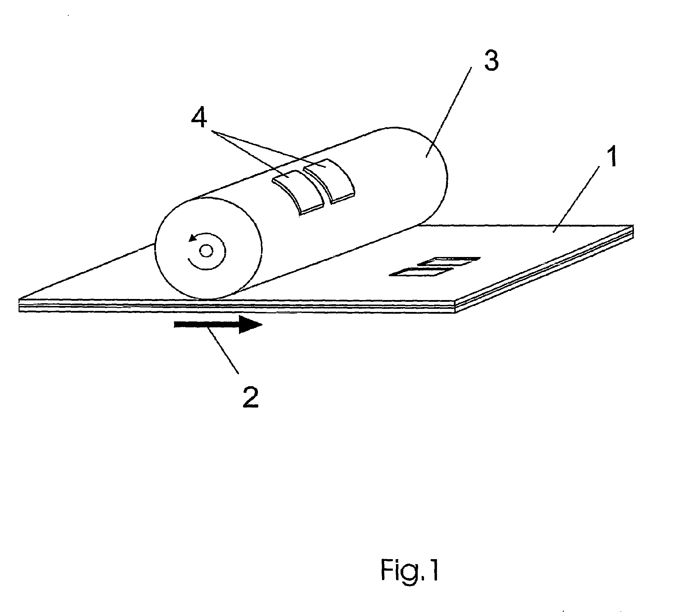

Aus Figur 1 ist in schematischer Ansicht die insgesamt mit 1 bezeichnete Ausgangsstruktur dargestellt, die in Richtung des Pfeils 2 zwischen zwei nicht dargestellten Spulen bewegt wird.

Der erfindungsgemäße Prägeschritt wird mittels eines auf der bewegten Ausgangsstruktur 1 abrollenden Prägezylinders 3 durchgeführt, auf dessen Mantelfläche quaderförmige Prägeformen 4 angeordnet sind.

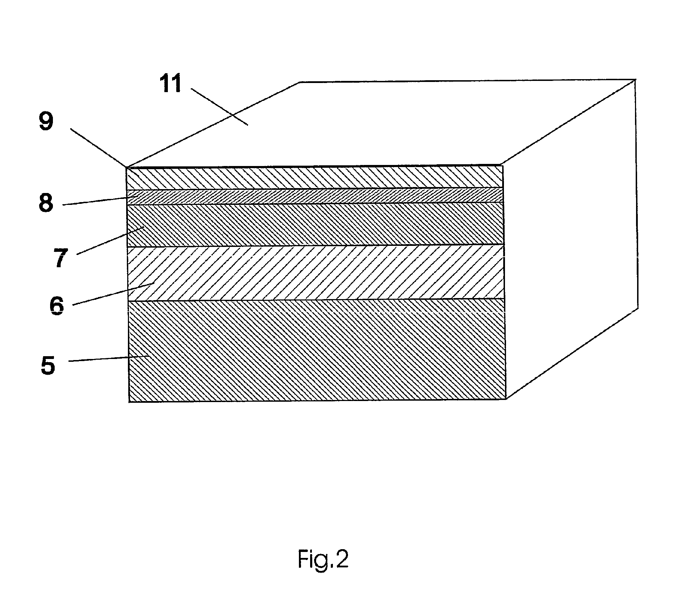

Der Schichtaufbau der Ausgangsstruktur ist aus Figur 2 erkennbar. Auf einer PET-Folie als Substrat 5 ist eine plastisch verformbare Prägeschicht 6 angeordnet. Oberhalb der Prägeschicht 6 befindet sich eine Schicht aus elektrisch halbleitendem Material, nachfolgend kurz Halbleiterschicht 7 genannt. Die Halbleiterschicht 7 ist durch eine isolierende Schicht 8 von einer elektrisch leitenden Schicht 9 getrennt.

Mittels des Prägezylinders 3 werden in einem Prägeschritt die oberhalb der Prägeschicht 6 befindlichen Schichten 7, 8, 9 sowie ggf. weitere Schichten abschnittsweise an senkrecht zu der Oberfläche 11 der Ausgangsstruktur 1 liegenden Schnittflächen abgeschert.

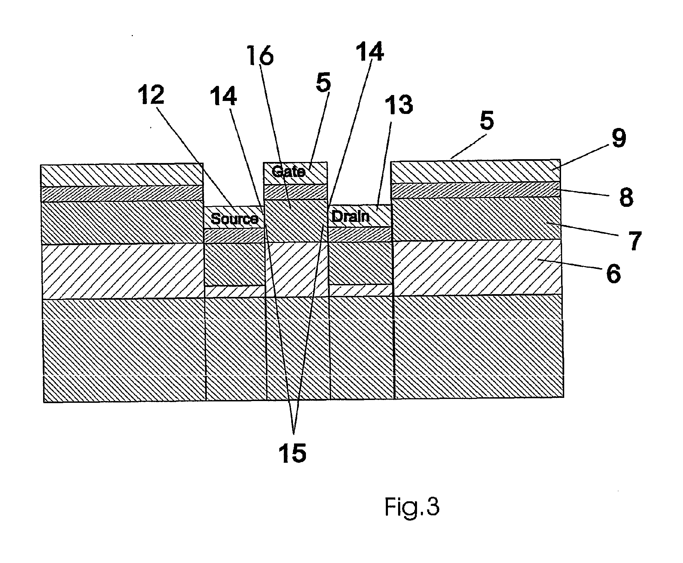

Der Prägeschritt wird nachfolgend anhand des Ausführungsbeispieles nach Figur 3 näher erläutert. Die Prägeformen 4 des Prägezylinders 3 drücken die in Figur 3 gezeigten äußeren Abschnitte 12, 13 in die plastisch verformbare Prägeschicht 6 hinein, während die Form der übrigen Schichten im wesentlichen unverändert bleibt. Dabei werden die Halbleiterschicht 7, die elektrisch leitende Schicht 9 sowie die dazwischen liegende elektrisch isolierende Schicht 8 senkrecht zu der Oberfläche 11 der Ausgangsstruktur 1 abgeschert. Dabei bilden sich senkrechte Schnittflächen an den abgescherten Schichten 7, 8, 9. Wie aus Figur 3 erkennbar, kommen die senkrechten Schnittflächen 14 der elektrisch leitenden Schicht 9 an den äußeren Abschnitten 12, 13 mit den senkrechten Schnittflächen 15 der elektrisch halbleitenden Schicht 7 in Kontakt. Des Weiteren ist erkennbar, dass sich die senkrechten Schnittflächen 14 zwischen abgescherten Abschnitten der elektrisch leitenden Schicht nicht mehr berühren.

Durch den einfachen Prägeschritt wird ein TFT-Transistor hergestellt. Die elektrisch leitende Schicht 9 in den äußeren Abschnitten 12, 13 bildet die Kollektor- bzw. Emitterelektrode, die in direktem Kontakt zu den senkrechten Schnittflächen der Halbleiterschicht 7 im mittleren Abschnitt 16 stehen. Die elektrisch leitende Schicht 9 des mittleren Abschnitts 16 bildet die Basiselektrode. Die Basiselektrode ist durch die isolierende Schicht 8, insbesondere ein Dielektrikum von der Halbleiterschicht 7 getrennt.

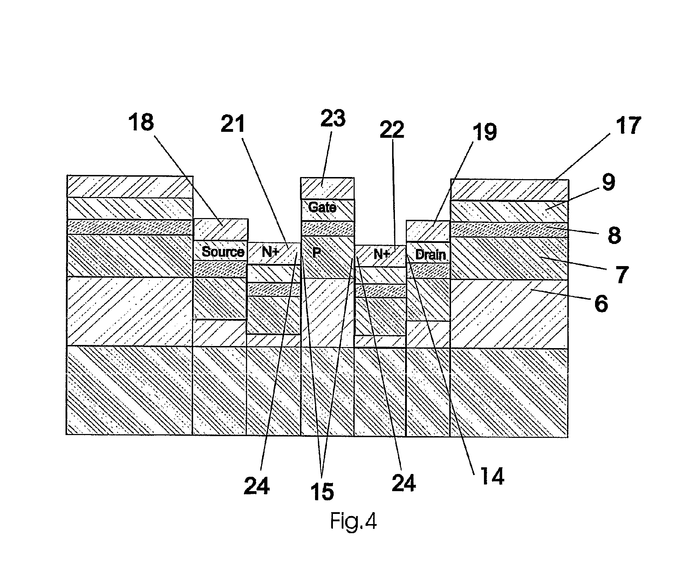

Das Ausführungsbeispiel nach Figur 4 unterscheidet sich von dem Ausführungsbeispiel nach Figur 3 dadurch, dass in der Ausgangsstruktur 1 oberhalb der elektrisch leitenden Schicht 9 eine weitere Halbleiterschicht 17 aus N+ dotiertem Silizium aufgebracht ist.

Diese zusätzliche N+ dotierte Halbleiterschicht 17 ermöglicht die Herstellung eines NPN-Halbleiterbauelementes.

Im Unterschied zu Figur 3 werden bei dem Ausführungsbeispiel nach Figur 4 nicht nur zwei äußere, sondern insgesamt vier Abschnitte in die Prägeschicht eingedrückt. Im einzelnen handelt es sich um die beiden äußeren Abschnitte 18, 19 sowie die unmittelbar von diesen eingeschlossenen Abschnitte 21, 22. Der mittlere Abschnitt 23 wird während des Prägeschrittes nicht in die Prägeschicht 6 eingedrückt und verbleibt daher auf dem Niveau der Ausgangsstruktur. Wie auch bei dem Ausführungsbeispiel nach Figur 3 werden jeweils nur die oberhalb der Prägeschicht 6 angeordneten Schichten 7, 8, 9 sowie 17 mit dem Prägewerkzeug in die Prägeschicht 6 eingedrückt.

Durch entsprechende Höhe der auf dem Prägezylinder 3 angeordneten quaderförmigen Prägeformen 4 wird die Prägetiefe der eingeschlossenen Abschnitte 21, 22 so bestimmt, dass die senkrechten Schnittflächen 24 der N+ dotierten Halbleiterschicht 17 mit den senkrechten Schnittflächen 15 der halbleitenden Schicht 7 in Kontakt kommen. Hierdurch wird ein Halbleiter mit einer N+-Zone, einer P-Zone sowie einer N+-Zone ausgebildet. Auf der parallel gegenüberliegenden Seite grenzen die senkrechten Schnittflächen der N+ dotierten Halbleiterschicht 17 an die senkrechten Schnittflächen 14 der elektrisch leitenden Schicht 9 in den äußeren Abschnitten 18, 19.

Die elektrisch leitende Schicht 9 in den äußeren Abschnitten 18, 19 bildet die Emitter- bzw. Kollektorelektrode des NPN-Transistors. Die P-Zone des NPN-Transistors wird von der Halbleiterschicht 7 in dem mittleren Abschnitt 23 gebildet, die über die isolierende Schicht 8 mit der Basis-Elektrode in Verbindung steht. Die Basis-Elektrode wird von der elektrisch leitenden Schicht 9 in dem mittleren Abschnitt 23 gebildet.

### Bezugszeichenliste:

| Nr. | **Bezeichnung** |
|---|---|
| 1. | Ausgangsstruktur |
| 2. | Pfeil |
| 3. | Prägezylinder |
| 4. | Prägeformen |
| 5. | Substrat |
| 6. | Prägeschicht |
| 7. | Halbleiterschicht |
| 8. | isolierende Schicht |
| 9. | elektrisch leitende Schicht |
| 10. | - |
| 11. | Oberfläche Ausgangstruktur |
| 12. | äußerer Abschnitt (Figur 3) |
| 13. | äußerer Abschnitt (Figur 3) |
| 14. | senkrechte Schnittfläche der leitenden Schicht 9 |
| 15. | senkrechte Schnittfläche der Halbleiterschicht 7 |
| 16. | mittlerer Abschnitt (Figur 3) |
| 17. | N+ dotierte Halbleiterschicht |
| 18. | äußerer Abschnitt (Figur 4) |
| 19. | äußerer Abschnitt (Figur 4) |
| 20. | - |
| 21. | eingeschlossener Abschnitt (Figur 4) |
| 22. | eingeschlossener Abschnitt (Figur 4) |
| 23. | mittlerer Abschnitt (Figur 4) |
| 24. | |
| 25. | |

## Patentansprüche

1. Verfahren zur Herstellung von elektronischen Einheiten in einer mehrlagigen ebenen Ausgangstruktur mit einer auf einem Substrat angeordneten, plastisch verformbaren Prägeschicht sowie einer ersten und zweiten Schicht oberhalb der Prägeschicht, wobei die erste und zweite Schicht eine unterschiedliche elektrische Leitfähigkeit aufweisen und zwischen der ersten und zweiten Schicht eine elektrisch isolierende Schicht angeordnet ist, wobei in einem Prägeschritt mittels eines Prägewerkzeugs die oberhalb der Prägeschicht angeordneten Schichten abschnittsweise an senkrecht zu der Oberfläche der Ausgangstruktur liegenden Schnittflächen abgeschert und so weit in die Prägeschicht gedrückt werden, dass die senkrechten Schnittflächen unterschiedlicher Schichten in Kontakt kommen.

2. Verfahren nach Anspruch 1, **dadurch gekennzeichnet, dass** die erste Schicht aus elektrisch leitendem und die zweite Schicht aus elektrisch halbleitendem Material besteht.

3. Verfahren nach Anspruch 1, **dadurch gekennzeichnet, dass** die erste Schicht aus elektrisch halbleitendem und die zweite Schicht aus elektrisch leitendem Material besteht.

4. Verfahren nach einem der Ansprüche 1-3, **dadurch gekennzeichnet, dass** die abgescherten Abschnitte so weit in die Prägeschicht gedrückt werden, dass die senkrechten Schnittflächen zwischen abgescherten Abschnitten der elektrisch leitenden Schicht sich nicht berühren.

5. Verfahren nach einem der Ansprüche 1-3, **dadurch gekennzeichnet, dass** die erste und zweite Schicht sowie die dazwischen liegende elektrisch isolierende Schicht abschnittsweise an parallel zueinander liegenden Schnittflächen abgeschert werden

6. Verfahren nach einem der Ansprüche 1 bis 5, **dadurch gekennzeichnet, dass** mindestens ein Abschnitt an senkrecht zu der Oberfläche der Ausgangstruktur liegenden Schnittflächen abgeschert und in die Prägeschicht gedrückt wird.

7. Verfahren nach einem der Ansprüche 1-5, **dadurch gekennzeichnet, dass** mindestens eine oberhalb der ersten und zweiten Schicht aufgebrachte weitere Schicht aus elektrisch halbleitendem Material mittels des Prägewerkzeugs abschnittsweise an senkrecht zu der Oberfläche der Ausgangstruktur liegenden Schnittflächen abgeschert und zusammen mit den übrigen Schichten in die Prägeschicht gedrückt wird.

8. Verfahren nach Anspruch 7, **dadurch gekennzeichnet, dass** mindestens vier Abschnitte an senkrecht zu der Oberfläche der Ausgangstruktur liegenden Schnittflächen abgeschert und in die Prägeschicht gedrückt werden.

9. Verfahren nach einem der Ansprüche 1-5, **dadurch gekennzeichnet, dass** mindestens eine unterhalb der ersten und zweiten Schicht auf der Prägeschicht aufgebrachte weitere Schicht aus elektrisch halbleitendem Material mittels des Prägewerkzeugs abschnittsweise an senkrecht zu der Oberfläche der Ausgangstruktur liegenden Schnittflächen abgeschert und zusammen mit den übrigen Schichten in die Prägeschicht gedrückt wird.

10. Verfahren nach Anspruch 9, **dadurch gekennzeichnet, dass** mindestens drei Abschnitte an senkrecht zu der Oberfläche der Ausgangstruktur liegenden Schnittflächen abgeschert und in die Prägeschicht gedrückt werden.

11. Verfahren nach einem der Ansprüche 7-10, **dadurch gekennzeichnet, dass** jede weitere Schicht aus dotiertem halbleitendem Material besteht.

12. Verfahren nach einem der Ansprüche 1-11, **dadurch gekennzeichnet, dass** der Prägeschritt an einer ruhenden Ausgangsstruktur durchgeführt wird.

13. Verfahren nach einem der Ansprüche 1-11, **dadurch gekennzeichnet, dass** der Prägeschritt an einer bewegten Ausgangsstruktur durchgeführt wird

14. Verfahren nach einem der Ansprüche 1-13, **dadurch gekennzeichnet, dass** der Prägeschritt mit einem quaderförmige Prägeformen aufweisenden Prägewerkzeug durchgeführt wird.

15. Verfahren nach Anspruch 13 und 14, **dadurch gekennzeichnet, dass** der Prägeschritt mittels eines auf der bewegten Ausgangsstruktur abrollenden Prägezylinders durchgeführt wird, auf dessen Mantelfläche die Prägeformen angeordnet sind.

16. Verfahren nach einem der Ansprüche 1-15, **dadurch gekennzeichnet, dass** nach dem Prägeschritt eine Beschichtung auf der Struktur aufgebracht wird.

17. Verfahren nach einem der Ansprüche 1-16, **dadurch gekennzeichnet, dass** die Struktur während und/ oder nach dem Prägeschritt mit elektromagnetischer Strahlung, insbesondere UV-Strahlung beaufschlagt wird.

18. Verfahren nach einem der Ansprüche 1-17, **dadurch gekennzeichnet, dass** zumindest für die erste und zweite Schicht ein Material mit unterschiedlichem Ausdehnungsverhalten verwendet wird.

19. Verfahren nach einem der Ansprüche 1-18, **dadurch gekennzeichnet dass** der Struktur während und/ oder nach dem Prägeschritt Wärmeenergie zugeführt oder von ihr abgeführt wird.

20. Verfahren nach einem der Ansprüche 1-19, **dadurch gekennzeichnet, dass** die Struktur während und/ oder nach dem Prägeschritt mit Schallschwingungen, insbesondere Ultraschallschwingungen beaufschlagt wird.

21. Verfahren nach einem der Ansprüche 1-20, **dadurch gekennzeichnet, dass** zumindest für die erste oder zweite Schicht ein Material mit fotochemisch aktivierbaren Substanzen zum Einsatz gelangt.

## Claims

1. A method for fabricating electronic units in a multilayer planar initial structure comprising a plastically deformable embossing layer disposed on a substrate as well as a first and second layer above the embossing layer, wherein the first and second layer have a different electrical conductivity and an electrically insulating layer is disposed between the first and second layer, wherein in an embossing step the layers disposed above the embossing layer are sheared off in sections by means of an embossing tool at interfaces located perpendicular to the surface of the initial structure and pressed so far into the embossing layer that the perpendicular interfaces of different layers come in contact.

2. The method according to claim 1, **characterised in that** the first layer consists of electrically conductive material and the second layer consists of electrically semiconducting material.

3. The method according to claim 1, **characterised in that** the first layer consists of electrically semiconducting material and the second layer consists of electrically conductive material.

4. The method according to any one of claims 1-3, **characterised in that** the sheared-off sections are pressed so far into the embossing layer that the perpendicular interfaces between sheared-off sections of the electrically conductive layer are not in contact.

5. The method according to any one of claims 1-3, **characterised in that** the first and the second layer as well as the interposed electrically insulating layer are sheared off in sections at interfaces located parallel to one another.

6. The method according to any one of claims 1 to 5, **characterised in that** at least one section at interfaces located perpendicular to the surface of the initial structure is sheared off and pressed into the embossing layer.

7. The method according to any one of claims 1-5, **characterised in that** at least one further layer of electrically semiconducting material applied above the first and second layer is sheared off in sections by means of the embossing tool at interfaces located perpendicular to the surface of the initial structure and is pressed together with the remaining layers into the embossing layer.

8. The method according to claim 7, **characterised in that** at least four sections are sheared off at interfaces located perpendicular to the surface of the initial structure and are pressed into the embossing layer.

9. The method according to any one of claims 1-5, **characterised in that** at least one further layer of electrically semiconducting material applied to the embossing layer below the first and second layer is sheared off in sections by means of the embossing tool at interfaces located perpendicular to the surface of the initial structure and is pressed together with the remaining layers into the embossing layer.

10. The method according to claim 9, **characterised in that** at least three sections are sheared off at interfaces located perpendicular to the surface of the initial structure and are pressed into the embossing layer.

11. The method according to any one of claims 7-10, **characterised in that** each further layer consists of doped semiconducting material.

12. The method according to any one of claims 1-11, **characterised in that** the embossing step is carried out on a stationary initial structure.

13. The method according to any one of claims 1-11, **characterised in that** the embossing step is carried out on a moving initial structure.

14. The method according to any one of claims 1-13, **characterised in that** the embossing step is carried out using an embossing tool having rectangular embossing dies.

15. The method according to claim 13 and 14, **characterised in that** the embossing step is carried out by means of an embossing cylinder unrolling on the moving initial structure, the embossing dies being disposed on the circumferential surface thereof.

16. The method according to any one of claims 1-15, **characterised in that** after the embossing step, a coating is applied to the structure.

17. The method according to any one of claims 1-16, **characterised in that** during and/or after the embossing step, the structure is exposed to electromagnetic radiation, in particular UV radiation.

18. The method according to any one of claims 1-17, **characterised in that** a material having different elongation behaviour is used at least for the first and second layer.

19. The method according to any one of claims 1-18, **characterised in that** during and/or after the embossing step, thermal energy is supplied to the structure or removed from said structure.

20. The method according to any one of claims 1-19, **characterised in that** during and/or after the embossing step, the structure is exposed to sonic vibrations, in particular to ultrasonic vibrations.

21. The method according to any one of claims 1-20, **characterised in that** a material comprising photochemically activatable substances is used at least for the first or second layer.

## Revendications

1. Procédé pour la réalisation d'unités électroniques dans une structure de départ plane à plusieurs couches avec une couche d'estampage apte à se déformer plastiquement disposée sur un substrat, ainsi qu'une première couche et une seconde couche au-dessus de la couche d'estampage, la première couche et la seconde couche ayant des conductivités différentes, et une couche électriquement isolante étant disposée entre la première couche et la seconde couche, une opération d'estampage au moyen d'un outil à estamper cisaillant par parties, le long de plans de coupe perpendiculaires à la surface de la structure de départ, les couches disposées au-dessus de la couche d'estampage et les enfonçant dans la couche d'estampage de sorte à amener les plans de coupe perpendiculaires des différentes couches en contact.

2. Procédé selon la revendication 1, **caractérisé en ce que** la première couche est réalisée dans un matériau conducteur de l'électricité et **en ce que** la seconde couche est réalisée dans un matériau semi-conducteur de l'électricité.

3. Procédé selon la revendication 1, **caractérisé en ce que** la première couche est réalisée dans un matériau semi-conducteur de l'électricité et **en ce que** la seconde couche est réalisée dans un matériau conducteur de l'électricité.

4. Procédé selon l'une des revendications 1 à 3, **caractérisé en ce que** les parties cisaillées sont enfoncées dans la couche d'estampage de sorte que les plans de coupe perpendiculaires situés entre les parties cisaillées de la couche conductrice de l'électricité ne se touchent pas.

5. Procédé selon l'une des revendications 1 à 3, **caractérisé en ce que** la première couche et la seconde couche, ainsi que la couche électriquement isolante disposée entre les deux, sont cisaillées par parties le long de plans de coupe parallèles les uns par rapport aux autres.

6. Procédé selon l'une des revendications 1 à 5, **caractérisé en ce qu'**au moins une partie est cisaillée le long de plans de coupe disposés perpendiculairement à la surface de la structure de départ et enfoncée dans la couche d'estampage.

7. Procédé selon l'une des revendications 1 à 5, **caractérisé en ce qu'**au moins une autre couche en un matériau semi-conducteur de l'électricité, disposée au-dessus de la première couche et de la seconde couche, est cisaillée par parties le long de plans de coupe disposés perpendiculairement à la surface de la structure de départ et enfoncée avec les autres couches dans la couche d'estampage au moyen de l'outil d'estampage.

8. Procédé selon la revendication 7, **caractérisé en ce qu'**au moins quatre parties sont cisaillées le long de plans de coupe disposés perpendiculairement à la surface de la structure de départ et enfoncées dans la couche d'estampage.

9. Procédé selon l'une des revendications 1 à 5, **caractérisé en ce qu'**au moins une autre couche en un matériau semi-conducteur de l'électricité, disposée en dessous de la première couche et de la seconde couche et sur la couche d'estampage, est cisaillée par parties le long de plans de coupe disposés perpendiculairement à la surface de la structure de départ et enfoncée avec les autres couches dans la couche d'estampage au moyen de l'outil d'estampage.

10. Procédé selon la revendication 9, **caractérisé en ce qu'**au moins trois parties sont cisaillées le long de plans de coupe disposés perpendiculairement à la surface de la structure de départ et enfoncées dans la couche d'estampage.

11. Procédé selon l'une des revendications 7 à 10, **caractérisé en ce que** chaque autre couche est réalisée en un matériau semi-conducteur dopé.

12. Procédé selon l'une des revendications 1 à 11, **caractérisé en ce que** l'opération d'estampage est réalisée sur une structure de départ immobile.

13. Procédé selon l'une des revendications 1 à 11, **caractérisé en ce que** l'opération d'estampage est réalisée sur une structure de départ en mouvement.

14. Procédé selon l'une des revendications 1 à 13, **caractérisé en ce que** l'opération d'estampage est réalisée au moyen d'un outil d'estampage pourvu de matrices d'estampage de forme parallélépipédique.

15. Procédé selon les revendications 13 et 14, **caractérisé en ce que** l'opération d'estampage est réalisée au moyen d'un cylindre d'estampage, sur l'enveloppe duquel sont disposées les matrices d'estampage, roulant sur la structure de départ en mouvement.

16. Procédé selon l'une des revendications 1 à 15, **caractérisé en ce que**, après l'opération d'estampage, un revêtement est appliqué sur la structure.

17. Procédé selon l'une des revendications 1 à 16, **caractérisé en ce que** la structure est exposée à un rayonnement électromagnétique, notamment un rayonnement UV, pendant et/ou après l'étape d'estampage.

18. Procédé selon l'une des revendications 1 à 17, **caractérisé en ce qu'**au moins pour la première couche et la seconde couche, il est fait appel à des matériaux avec des comportements à la dilatation différents.

19. Procédé selon l'une des revendications 1 à 18, **caractérisé en ce que** de l'énergie thermique est apportée à la structure ou est évacuée par celle-ci pendant et/ou après l'étape d'estampage.

20. Procédé selon l'une des revendications 1 à 19, **caractérisé en ce que** la structure est soumise à des vibrations acoustiques, notamment des vibrations ultrasoniques, pendant et/ou après l'étape d'estampage.

21. Procédé selon l'une des revendications 1 à 20, **caractérisé en ce qu'**un matériau comportant des substances activables par des moyens photochimiques est mis en oeuvre au moins pour la première ou la seconde couche.
